# EUROPEAN PATENT APPLICATION

(11) **EP 1 843 472 A1**
(43) Date of publication of application: **10.10.2007**
(21) Application number: 07105546.1
(22) Date of filing: 03.04.2007
(51) Int. Cl.: H03L 7/089, H03L 7/093

(54) **Method for mitigating single event effects in a phase locked loop**

(30) Priority: 04.04.2006 US 397265
(71) Applicant: Honeywell International, Inc., Morristown, New Jersey 07962 (US)
(72) Inventor: Roper, Weston, Shakopee, MN 55379 (US)
(74) Representative: Haley, Stephen

(57) **Abstract**

A method for operating a Phase Locked Loop (PLL) that mitigates radiation event influence on a phase signal. The method is implemented on a PLL having two loop filters. The first filter is a proportional (resistive) loop filter that is operated so that it scales and/or clips the influence out of the phase signal and produces a fine tuning signal. The second filter, on the other hand, is an integral (capacitive) loop filter that dampens the influence and produces a coarse tuning signal. A summing node may then combine the fine and coarse tuning signals and communicate the combined output signal to a VCO. Because the phase signal has been separately filtered, the VCO produces a waveform that is less prone to cause the PLL to report a loss of lock.

## Description

The present invention relates generally to a method of operating a phase locked loop, and more particularly, a method for mitigating single event effects in a phase locked loop.

Analog electrical systems and communication systems frequently employ Phase Locked Loops (PLL). In today's high performance systems operating within increasingly stringent timing constraints, digital electronic circuits are beginning to include PLLs. For example, Application Specific Integrated Circuits (ASICs), used in a variety of circuit applications, typically include on-chip PLLs for clock signal distribution.

Key advantages that PLLs bring to clock distribution are phase/delay compensation, frequency multiplication and duty cycle correction. A PLL enables one periodic signal or clock signal to be phase-aligned to frequency multiples of a reference clock signal. As the name implies the output of the PLL locks onto the incoming reference clock signal and generates a periodic output signal with a frequency substantially equal to a multiple of the average frequency of the reference clock. When the output PLL signal tracks the reference signal, the PLL is said to be "locked."

A PLL, however, will only remain locked over a limited frequency range or shift in frequency called a hold-in or lock range. The PLL generally tracks the reference signal over the lock range, provided the reference frequency changes slowly. If the frequency changes too quickly, the PLL will lose lock. Losing lock is undesirable because it may disrupt circuitry and applications downstream to the PLL.

In radiation environments (such as at high altitude or in outerpace), a PLL may lose lock even if the reference signal does not deviate from the lock range. This generally occurs when an ion, or other charged particle, transitions through circuit elements (field effect transistors, capacitors, etc.,) of the PLL. Because these circuit elements are constructed from semiconductor materials, an incident ion, for example, may deposit a charge that causes a temporary voltage shift, or a glitch, at any one element. In some instances, the glitch may cause a state change (i.e., a change from "high" to "low" or vice versa).

When a radiation event causes a state change or a glitch, it is commonly referred to as a Single Event Effect (SEE). SEEs are quite problematic; an incident ion, for instance, may cause a phase detector to report an erroneous phase difference on a phase difference signal. Alternatively, an incident ion may disrupt normal operation of a charge pump and may also deleteriously influence the phase signal. In both of these instances, the radiation event may only cause a brief disruption, and the PLL may quickly recover. Despite a quick recovery, the PLL may, nevertheless, report lock loss. Unfortunately, when a lock loss is reported by the PLL, down stream circuits may be required to re-initialize. The PLL may also be required to be reset. For these reasons and others, erroneously reported lock loss may reduce a system's overall performance. Therefore, it is desirable to mitigate radiation event influences on a phase difference signal in a PLL.

A method of operating a PLL is presented. The method mitigates radiation event influences on a phase difference signal, such as those associated with a radiation environment or an incident ion. By lessening the influence, an erroneously reported loss of lock may be averted.

The disclosed method is implemented on a phase locked loop having two loop filters. The first filter is a proportional loop filter and the second filter is an integral loop filter. In one respect, the PLL may be viewed as having a proportional module and an integral module. The proportional module includes the proportional filter, a bias generator, and a charge pump. The integral module includes the integral filter, a second bias generator, and a second charge pump. A summing module may then combine the outputs of both modules. An output of the summing module may drive a Voltage Controlled Oscillator (VCO).

In general, the presented method lessens the influence of radiation effects on the phase signal by (i) scaling and/or clipping the influence (via the proportional filter) and (ii) dampening the influence (via the integral filter). Filtering the phase signal with the proportional filter produces a fine tuning signal that responds linearly to changes in the phase signal. The fine tuning signal has a predetermined range that may be established by a charge pump and/or a resistive element.

Filtering the phase signal with the integral filter, on the other hand, produces a coarse tuning signal that gradually responds to changes in the phase signal. When the phase signal glitches, the integral filter dampens the effect of the glitch by distributing it across the coarse tuning signal. To achieve this gradual response, the integral filter may include a capacitive element. The capacitive element may, for example, prevent the PLL from reporting a loss of lock until the radiation event has influenced the phase signal for a predetermined amount of time.

After the appropriate filtering, the fine and coarse tuning signals may then tune a VCO. In one example, the fine and coarse tuning signals are summed into a combined current signal that tunes the VCO. This may be carried out by communicating a fine tuning voltage signal to a first bias generator and a coarse tuning voltage signal to a second bias generator. The bias generators produce fine and coarse tuning current signals that may be added together and then supplied to the VCO.

These as well as other aspects and advantages will become apparent to those of ordinary skill in the art by reading the following detailed description, with reference where appropriate to the accompanying drawings. Further, it is understood that this summary is merely an example and is not intended to limit the scope of the invention as claimed.

In the Drawings;

Certain example embodiments are described below in conjunction with the appended drawing figures, wherein like reference numerals refer to like elements in the various figures, and wherein:
Figure 1 is a block diagram of a PLL;
Figure 2A is a schematic of a prior art loop filter;
Figure 2B is a graph depicting a glitch on a charge pump current of the loop filter of Fig. 2A;
Figure 2C is a graph depicting a bias that has been influenced by the glitch of Fig. 2B and causes a PLL to lose lock;
Figure 3A is a schematic of a proportional (resistive) loop filter;
Figure 3B is a graph depicting a scaled and clipped bias vs. a non-scaled and non-clipped bias;
Figure 4A is a schematic of an integral (capacitive) loop filter;
Figure 4B is a graph depicting a dampened bias responsive to a glitch in a charge pump current;
Figure 5 is a graph depicting fine, coarse, and combined tuning signals which have been influence by the glitch of Fig. 2B but have not caused a loss of lock;
Figure 6 is a flow diagram of a method of operating a PLL;
Figure 7 is a schematic diagram of a circuit that may be used in place of two bias generators and a summing node..

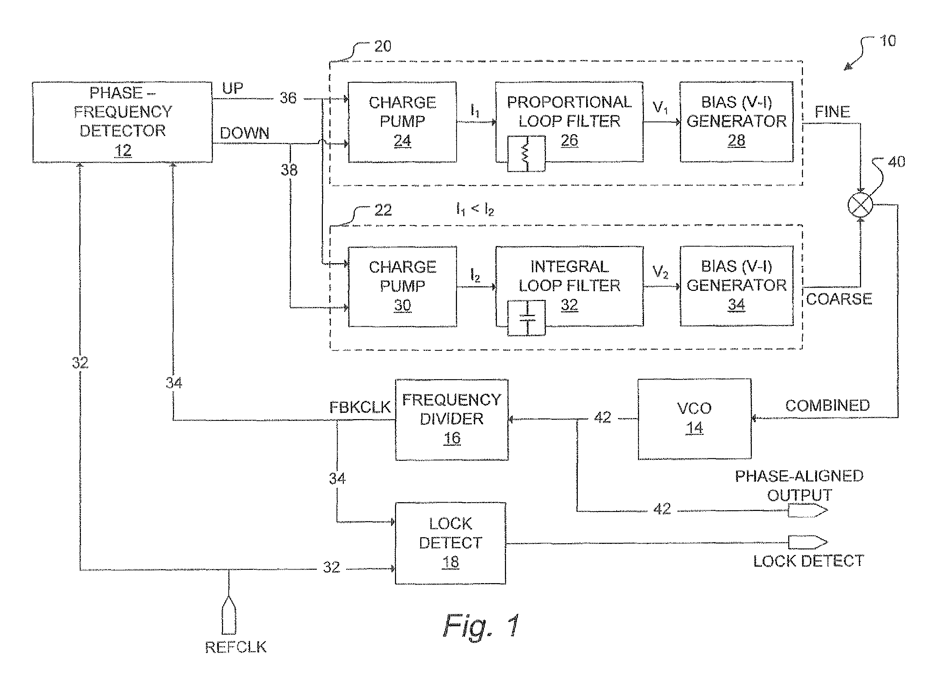

Turning now to the figures, Fig. 1 is an example PLL 10 that receives a reference clock signal and produces a phase-aligned output signal. To indicate whether or not the output signal is locked onto the reference signal, the PLL also outputs a lock detect signal. At a component level, PLL 10 includes a phasefrequency detector 12, a VCO 14, a frequency divider 16, and a lock detector 18. To mitigate radiation event influences and to tune VCO 14, PLL 10 also includes a proportional module 20 and an integral module 22. Proportional module 20 includes a charge pump 24, a proportional loop filter 26, and a bias generator 28. Integral module 22 includes a charge pump 30, an integral loop filter 32, and a bias generator 34. It should be noted that charge pumps 24 and 26, proportional filter 26, and integral filter 28 are each separate components; the proportional and integral filters do not share a common charge pump. Although only shown as receiving and outputting single-ended signals, charge pumps 24 and 30 may be differential charge pumps that each include PMOS and NMOS current sources.

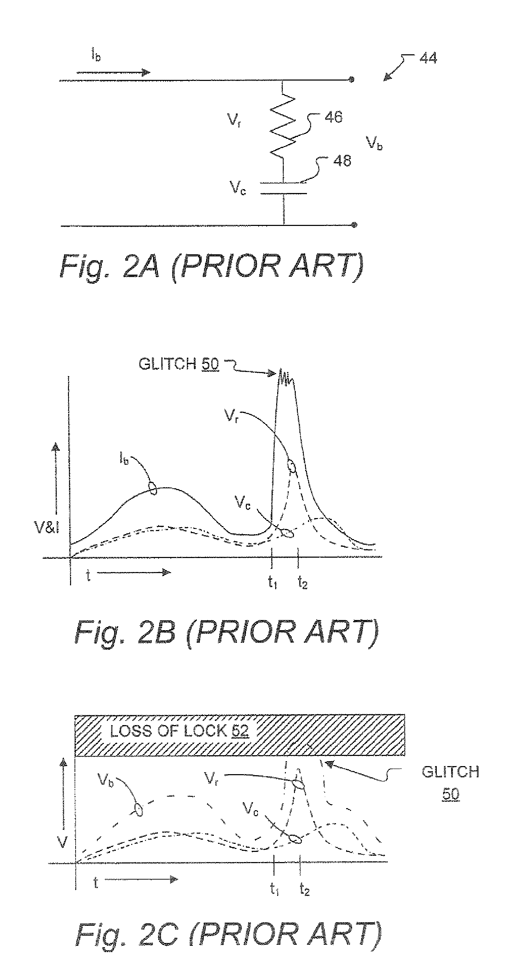

In operation, the phase detector 12 receives the reference signal via a signal line 32 and a derived (or feedback) clock signal via a signal line 34. In general, phase detector 12 produces a phase difference signal in the form of up and down voltage pulses respectively on signal lines 36 and 38. In most instances, the phase signal is indicative of a phase/frequency difference between the reference and feedback signals. If the phase/frequency difference occurs in one direction, the phase detector outputs "up" pulses until the reference and feedback signals are once again aligned. If the phase/frequency difference occurs in an opposite direction, the phase detector outputs "down" pulses to bring the reference and feedback signals back into alignment. In alternative examples, the phase signal may take on other forms. For instance, instead of being a voltage signal, the phase signal may be a current signal. After receiving the phase signal, proportional module 20 filters the phase signal and produces a fine tuning signal. In a similar manner, integral module 22 filters the phase signal and produces a coarse tuning signal. The manner in which these modules produce the fine and coarse tuning signals will be further described with reference to Fig. 2. Next, a summing node 40 adds the fine and coarse tuning signals to produce a combined signal. After the summation, VCO 14 receives the combined signal and uses it to produce a waveform on a signal line 42. The resultant waveform is the output signal of PLL 10.

In addition to serving as the output, the output signal also provides feedback. PLL 10 may first communicate the output signal to frequency divider 16 (for increasing the frequency of the output signal). After the output signal is divided at frequency divider 16, PLL 10 uses it as the feedback signal. Signal line 34 then closes a feedback path of PLL 10 by communicating the feedback signal to phase detector 12. Additionally, signal line 34 also communicates the feedback signal to lock detect 18. Lock detect 18 compares the reference signal to the feedback signal and produces a lock detect signal, which indicates whether or not the reference and feedback signals are within lock range.

As mentioned above, radiation influences may cause a PLL to erroneously report a loss of lock. This occurs, for instance, when circuitry (within or upstream to the PLL) is exposed to a radiation event and either immediately or eventually causes the phase signal to glitch. Because of the sudden and unpredictable nature of this glitch, conventional loop filters typically cannot filter the glitch out of the phase signal. Thus, the glitch propagates through the filter to a VCO tuning signal, and causes a VCO to output an erroneous waveform. The VCO eventually communicates this erroneous waveform to a lock detector, which then outputs a lock detect signal indicating a loss of lock condition. As a result, downstream circuits as well as the conventional PLL may need to be reset and the PLL's performance may be degraded.

In a conventional PLL, a charge pump typically generates a current pulse, which it communicates to a conventional loop filter. Fig. 2A shows a basic circuit diagram of a conventional loop filter 44 that comprises a resistive element 46 and a capacitive element 48. In most circumstances, loop filter 44 is more complex than the schematic of Fig. 2A. For the most part, however, this schematic generally conveys both the resistive and capacitive elements that a conventional loop filter uses to convert a charge pump current (I_{b}) into a filtered voltage (V_{b}).

Fig. 2B is a graph of I_{b}, a responsive voltage across resistive element 46 (Vᵣ), and a responsive voltage across capacitive element 48 (V_{c}). During normal operation, a charge pump supplies I_{b} to the loop filter, which oscillates over time and provides feedback that is responsive to changes in a phase signal. Fig. 2B shows I_{b} during normal operation and it also shows a glitch 50 that occurs at time t₁. Glitch 50, for instance, is a result of a radiation event influence on a phase signal. At a time, t₂, I_{b} decreases and eventually returns to normal operation.

Consequently, however, when I_{b} glitches, it causes Vᵣ to spike and V_{c} to gradually increase. Because Vᵣ occurs across a resistive element, it generally responds with a linear response to the spike. And V_{c,} because it occurs across a capacitive element, responds with a time-averaged response to the spike.

Unfortunately, loop filter 44 does not distinguish between Vᵣ and V_{c}. Instead, Vᵣ and V_{c} together establish V_{b}, which a PLL will ultimately communicate to a downstream VCO. (Typically, V_{b} is first communicated to a bias generator that converts V_{b} into a current signal; this current signal is then communicated to the VCO. Current signals, in general, are more stable and controllable and, therefore, allow a VCO to create a more precise waveform.)

When V_{b} is too high (or low), it may create a waveform on the downstream VCO that is out of the lock range associated with a lock detector. When glitch 50 occurs on the phase signal of the conventional PLL, it will pass through the loop filter and ultimately cause a loss of lock at the lock detector. To demonstrate, Fig. 2C shows V_{b}-the combination of Vᵣ and V_{c}-both inside and outside of a loss of lock zone 52. The loss of lock zone 52 is a zone where V_{b} will cause a lock detector to report a loss of lock. V_{b} creates a loss of lock shortly after time t₁, despite the recovery at time t₂.

However, if glitch 50 were to occur on the phase signal of PLL 10, it would not cause lock detector 18 (see Fig. 1) to report loss of lock. Instead, because proportional module 20 and integral module 22 separately filter the phase signal, they mitigate glitch 50 and prevent it from causing an erroneous waveform on VCO 14 and an erroneous reported loss of lock at lock detector 18. PLL 10's mitigation of glitch 50, via proportional module 20 and integral module 22, is next described below with reference to Figs. 2-6.

To mitigate glitch 50, the proportional module 20 provides a first type of filtering by clipping the phase signal when it glitches. To clip the phase signal, charge pump 24 may be current limited and proportional loop filter 26 may be substantially resistive. As a second type of filtering, integral module 22 dampens glitch 50 with integral loop filter 32, which may be substantially capacitive. After the appropriate filtering, summing node 40 combines outputs of the proportional and integral modules (i.e., fine and coarse tuning signals) and produces a combined signal for VCO 14.

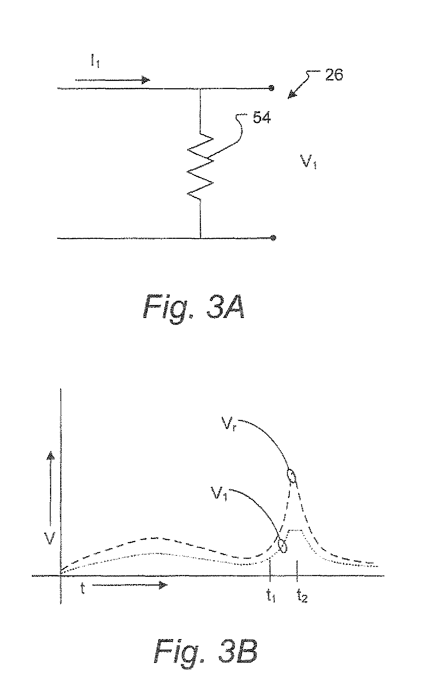

At a simplified level, Fig. 3A shows a schematic diagram of the proportional loop filter 26. In general, loop filter 26 may be more complex than the schematic of Fig. 3A. However, the schematic of Fig. 3A generally conveys that proportional loop filter 26 is resistive and not capacitive.

In Fig. 3A, a proportional filter 26 first receives a phase signal from charge pump 26 in the form of a current I₁. Then, proportional filter 26 converts I₁ into a voltage V₁ via a resistance 54. To scale the effect of radiation event influences, I₁ may be less in magnitude than I_{b} (see Figs. 2A-B). Charge pump 26, for example, may be similar in nature to a conventional charge pump, however, it may be modified to produce reduced bias currents. In one embodiment, I₁ may be an order of magnitude less than I_{b}. As a result, when I₁ glitches during a radiation event influence, I₁ will not increase as dramatically as I_{b} does during the same influence.

In other embodiments, resistance 54 may be less than resistance 46. By having a reduced resistance, proportional filter 26 will generate less voltage across resistance 54 than the voltage loop filter 44 generates across resistance 46. Therefore, when glitch 50 occurs, the linear response of the proportional filter 26 will be less substantial than that of loop filter 44.

In yet another embodiment, charge pump 24 may limit the range of I₁. For instance, charge pump 24 may include a current limiter that establishes a floor and a ceiling of I₁ so that I₁ is clipped when it deviates beyond either the floor or the ceiling.

In even further embodiments, I₁ and V₁ may be tailored by including some or all of the features of the embodiments described above. For instance, a charge pump having a reduced and limited range (relative to a conventional charge pump) may generate I₁. Then, a proportional filter having a decreased resistance (relative to resistance 46) may receive I₁ and establish a voltage V₁. Overall, the goal of the proportional filter 26 and/or charge pump 24 is to limit the gain of the proportional module 20. For example, the gain of the proportional module 20 is limited so that V₁ may only reach a certain level before it clips. In effect, proportional filter 26 will not have enough energy to cause VCO 14 to lose lock or cause excessive jitter. Although the gain of the proportional module 20 may be high (relative to integral module 22), it is limited so that disturbances that pass from the proportional module's resistor-only filter to VCO 14 are not large enough to cause the PLL to lose lock or cause excessive jitter.

As a comparison, Fig 3B shows V₁ relative to Vᵣ (see Figs. 2A-C). V₁ linearly responds to changes in the phase signal, however, at t₁, when the phase signal glitches, it is clipped. V₁ is also reduced in magnitude relative to Vᵣ.

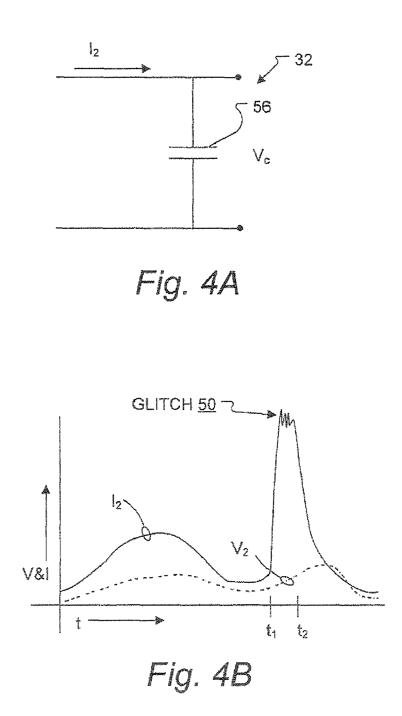

Next, at a simplified level, Fig. 4A shows a schematic diagram of the integral loop filter 26. In a similar fashion to proportional filter 26, integral filter 32 may be more complex than the schematic of Fig. 4A. However, the schematic of Fig. 4A generally conveys that integral filter 32 is capacitive and not resistive.

In Fig. 4A, integral filter 32 first receives a phase signal from charge pump 30 in the form of a current I₂, which integral filter 32 converts into a voltage V₂ via a capacitance 56. To further mitigate radiation event influences, V₂, instead of linearly responding to changes in I₂, responds in a time-averaged manner. Overall, the goal of the integral filter 32 is to limit the gain of the integral module 22 with respect to proportional module 22. (Because the integral filter 32 does not use a resistive element to filter, it resembles a single pole system and will effectively filter an SEE induced glitch).

To demonstrate, Fig. 4B shows a graph of I₂ and V₂. At time t₁, I₂ spikes as a result of glitch 50. V₂ is then a time-average response to changes in I₂. The time-average nature of V₂ tends to dampen any sudden changes in I₂. In general, the choice of the capacitance value may determine the shape and magnitude of V₂. In addition, this capacitance value may be tailored so that a glitch may have to occur on I₂ for a pre-determined amount of time before the change in V₂ is substantial enough to cause lock detector 18 to report a loss of lock. In one embodiment, I₂ may be the same or a similar current to I_{b} (see Figs. 2A-B). In an alternative embodiment, I₂ may be an order of magnitude larger than I₁ (see Fig. 3A).

Then, to produce fine and coarse tuning currents, bias generator 28 converts V₁ into a fine tuning current and bias generator 34 converts V₂ into a coarse tuning current. Summing node 40 next combines the fine and coarse tuning currents into a combined signal, which is communicated to VCO 14.

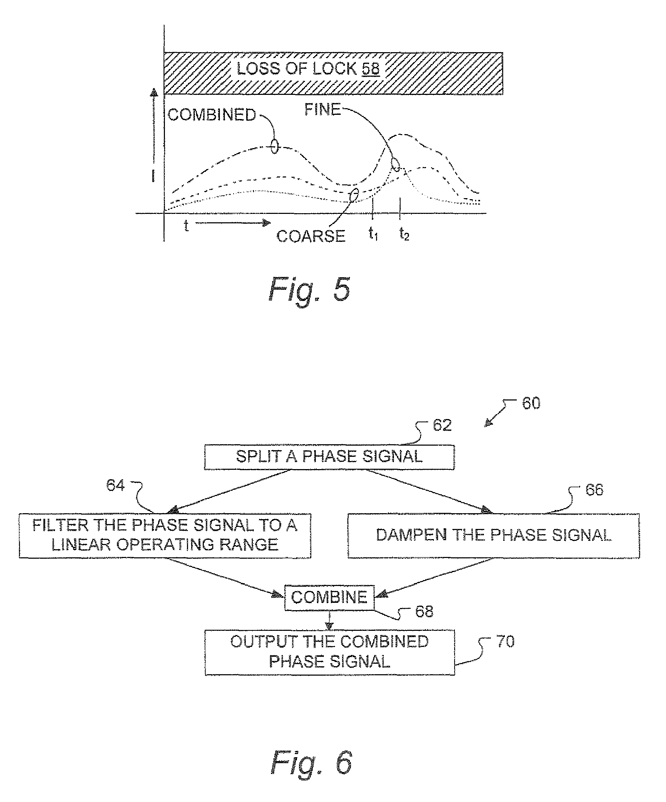

Fig. 5 is a graph showing the fine, coarse, and combined signals over time. In this example, these signals are current signals. In alternative embodiments, however, they may take on a variety of other forms, such as voltage signals. In Fig. 5 and after time t₁ (after glitch 50 occurs), the fine tuning current ramps up and eventually clips. The coarse tuning current, on the other hand, responds in a time-averaged manner such that the peak in the coarse tuning current occurs well after glitch 50. As a result, and in contrast to V_{b} (see Figs. 2A and 2C), the summing current stays below a loss of lock zone 58. Thus, lock detector 18 (see Fig. 1) does not report a loss of lock. As a result, PLL 10 and circuits downstream to it do not need to be reset or reinitialized. Instead, at time t₂, PLL 10 may recover from glitch 50 and it may continue with normal operation.

By separating the phase signal in the manner described above, a PLL may be operated to increase its tolerance to radiation events and influences. In a general manner, Fig. 6 shows a method 60 for operating a PLL that filters a radiation influence out of a phase signal. At block 62, a PLL splits a pre-filtered phase signal and communicates the pre-filtered phase signal to separate filters. The first filter, at block 64, limits the phase signal to a linear operating range. This linear operating range may scale down the pre-filtered phase signal and/or clip it. The second filter, at block 66, dampens (via a capacitor, for instance) changes in the phase signal. At block 68, separately filtered versions of the phase signal are combined. Then, at block 70, the combined phase signal is output, thus allowing a PLL to be more tolerant to a radiation event influence.

To further increase radiation tolerance, a PLL may include other components which may be optimized for radiation environments and radiation hardened applications. The phase detector, charge pump, loop filters, and VCO, for instance, may include circuit elements which are spaced at appropriate distances in order to reduce the likelihood of a an SEE event upsetting an entire component. In addition, to accommodate these circuit elements, the phase detector may use multiples of a clocking frequency in order to produce the appropriate up and down voltage pulses.

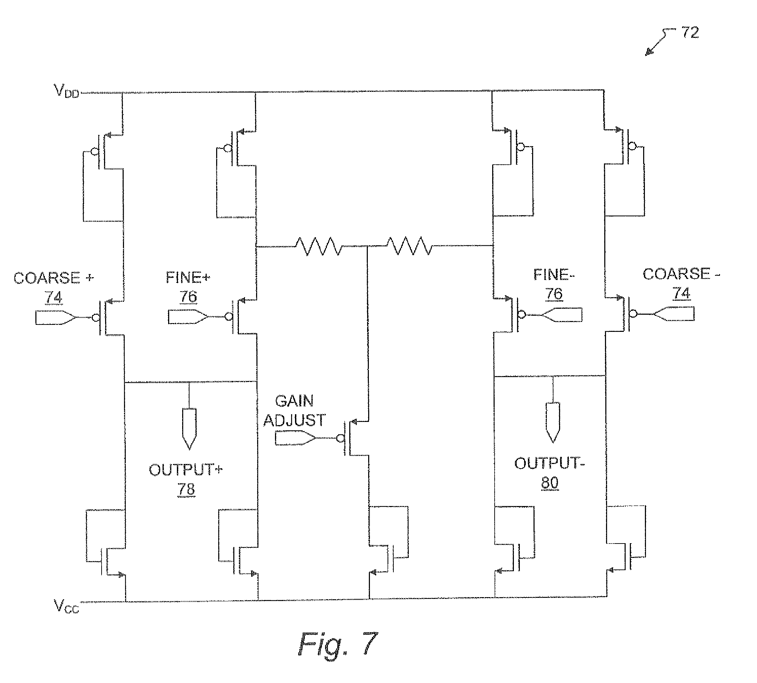

Consequently, it should be understood that a variety of PLLs may include various components and circuit elements in order to perform the above described methods. For instance, Figs. 1, 3A, 4B, show circuitry that primarily uses single-ended inputs and outputs. In alternative embodiments, a PLL may include components that use differential inputs and/or outputs. In addition, certain components may be combined. For instance, Fig. 7 shows a circuit 72 that combines bias generators 28, 34, and 40. In Fig. 7, coarse tuning inputs 74 are used to tune a first differential pair and fine tuning inputs 76 are used to tune a second differential pair. Outputs 78 and 80 may then produce a differential signal that drives a VCO. By producing a differential signal that uses the described method to separate the coarse and fine tune signals, a PLL may have an increased tolerance to SEE events. Moreover, other circuits may be conceived that take advantage of the described methods.

Therefore, the illustrated embodiments are examples only and should not be taken as limiting the scope of the present invention. The claims should not be read as limited to the described order or elements unless stated to that effect. Therefore, all embodiments that come within the scope and spirit of the following claims and equivalents thereto are claimed as the invention.

## Claims

1. A method for operating a Phase Locked Loop (PLL), comprising:
filtering an unfiltered phase difference signal with a proportional loop filter that outputs a substantially linear response to changes in the phase signal;
upon a radiation event influencing the unfiltered phase signal, clipping the influence with the proportional filter;
filtering the un-filtered phase signal with an integral loop filter that outputs a time-averaged response to changes in the phase signal; and
upon the radiation event influencing the unfiltered phase signal, dampening the influence with the integral filter.

2. The method as in claim 1, wherein a Voltage Controlled Oscillator (VCO) uses the linear response as a fine tuning signal and the time-averaged response as a coarse tuning signal.

3. The method as in claim 1, further comprising:
summing the linear response and the time-averaged response into a combined signal; and
tuning a VCO with the combined signal.

4. The method as in claim 1, wherein clipping and dampening the radiation event influence prevent the PLL from losing lock.

5. The method as in claim 1, further comprising:
with a first charge pump, converting the unfiltered phase signal to a first current;
with a second charge pump, converting the unfiltered phase signal to a second current;
supplying the first current to the proportional filter; and
supplying the second current to the integral filter.

6. The method as in claim 5, wherein the first charge pump limits the first current to an output range, thereby establishing a predetermined range of the linear response.

7. The method as in claim 6, wherein the first current is less in magnitude than the second current, thereby causing the first current to be less sensitive to changes in the phase signal than the second current.

8. The method as in claim 6, wherein the first charge pump includes a current limiter for establishing a floor and a ceiling of the output range of the first charge pump.

9. The method as in claim 8, wherein the proportional filter includes a resistive element that receives the first current, thereby establishing a voltage level of the linear response.

10. The method as in claim 9, wherein the integral filter includes a capacitive element that receives the second current, thereby establishing a voltage level of the time-averaged response.
